(19) Europäisches Patentamt
European Patent Office
Office européen des brevets

(11) Numéro de publication: **0 556 183 B1**

(12) # FASCICULE DE BREVET EUROPEEN

(45) Date de publication du fascicule du brevet: **23.08.95**

(51) Int. Cl.$^6$: **D06M 10/10**, C23C 16/50

(21) Numéro de dépôt: **91914329.7**

(22) Date de dépôt: **31.07.91**

(86) Numéro de dépôt internationale :
**PCT/EP91/01488**

(87) Numéro de publication internationale :
**WO 92/03591 (05.03.92 92/06)**

(54) **TRAITEMENT DE FIBRES TEXTILES ET DISPOSITIF POUR LEDIT TRAITEMENT.**

(30) Priorité: **22.08.90 EP 90870131**

(43) Date de publication de la demande:
**25.08.93 Bulletin 93/34**

(45) Mention de la délivrance du brevet:
**23.08.95 Bulletin 95/34**

(84) Etats contractants désignés:
**BE DE FR GB IT NL**

(56) Documents cités:
**EP-A- 0 068 775**
**US-A- 4 870 030**

**IEEE Electron Device Letters, vol. EDL-8, no. 9, septembre 1987, (New York,US), M.M. Moslehi et al.: "Formation of MOS gates by rapid thermal/microwave remote-plasma multiprocessing", pp. 421-424**

(73) Titulaire: **SOMMER S.A.**
**29, avenue des Champs-Pierreux**
**F-92022 Nanterre Cédex (FR)**

(72) Inventeur: **CALLEBERT, Franck**
**17, place Philippe-Lebon**
**F-59000 Lille (FR)**
Inventeur: **DUPRET, Christian**
**39, rue Georges-Clémenceau**
**F-59110 La Madeleine (FR)**
Inventeur: **DESSAUX, Odile**
**84, rue des Stations**
**F-59800 Lille (FR)**
Inventeur: **GOUDMAND, Pierre**
**2/53 Rés. Citeaux,**
**Parc S.-Maur**
**F-59800 Lille (FR)**

(74) Mandataire: **Van Malderen, Michel et al**
**Office van Malderen**
**Place Reine Fabiola 6/1**
**B-1080 Bruxelles (BE)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).



Rank Xerox (UK) Business Services
(3.10/3.09/3.3.3)

## Description

### Objet de l'invention

La présente invention concerne le traitement de surface de fibres textiles par un dépôt d'un film obtenu par polymérisation qui permet de conférer aux fibres notamment des propriétés d'anti-salissures et d'anti-mouillabilité.

La présente invention concerne également le dispositif pour la mise en oeuvre du procédé.

### Description de l'art antérieur

Les techniques d' ennoblissement du textile ont pris une place primordiale dans les opérations de finissage dans l'industrie des revêtements de sols et/ou de murs. En particulier, ces techniques permettent d'obtenir des propriétés finales intéressantes telles que l'anti-mouillabilité ou l'anti-salissure.

Il est connu d'utiliser pour le finissage de revêtements textiles des sprays de résine fluorée qui permettent de "gainer" par dépôt de résine les fibres constituant le revêtement textile en leur conférant ainsi un caractère d'anti-mouillabilité.

Néanmoins cette manière de procéder ne donne pas des résultats très satisfaisants. En effet, ce dépôt par pulvérisation (spray) génère un traitement hétérogène à la surface des fibres.

D'autre part, ce type de gainage supporte mal l'usure produite par la circulation et possède donc une tendance à se fissurer laissant ainsi la possibilité aux agents responsables des taches de s'infiltrer entre la couche de résine et la fibre, rendant ainsi le revêtement indétachable.

On connaît également l'utilisation de tannins synthétiques (soil release) comme technique d'ennoblissement, mais il s'agit de procédés particulièrement lourds à mettre en oeuvre.

Il a été proposé dans le document EP-A-0 068 775 (TORAY INDUSTRIES) d'améliorer les propriétés tinctoriales d'un tissu en provoquant des irrégularités (cratères) extérieures des fibres de surface à l'aide d'un plasma froid. Ce document n'implique pas l'utilisation d'un monomère et ne provoque pas l'amélioration des propriétés visées selon la présente invention.

Par le document US-A-4 870 030 (MARKUNAS), on connaît une technique de production de couches de semi-conducteurs sur un substrat à l'aide d'une technique de décharge délocalisée (remote plasma).

Le procédé n'implique pas de polymérisation d'un monomère mais concerne un dépôt de couches minces utilisant des précurseurs non-organiques. Le générateur utilisé est un générateur RF (radiofréquence) à 13,56 MHz et le procédé est discontinu.

Dans IEEE ELECTRON DEVICE LETTERS, Vol. EDL-8, n° 9, Sep. 1987, pp. 421-424, New-York, U.S.; M.M. MOSLEHI et al. : "Formation of MOS gates by rapid thermal/microwave remote-plasma multiprocessing", on décrit la technique Remote Plasma Enhanced Chemical Vapor Deposition (RPECVD) pour le dépôt de films métalliques (tungstène, silicium,...).

Le dépôt est assisté par l'illumination intense d'une lampe Tungstène (UV) et par le chauffage important du substrat (450 à 1150°C). Il ne s'applique pas à la polymérisation.

L'utilisation de plasmas de décharge pour la polymérisation a en outre été décrite dans H.V. Boenig, Fundamentals in plasma chemistry and technology, technomic pub. Co. Lancaster-Basel (1988); H. Yasuda, Plasma polymerization, Academic Press, New York (1985); G. Akovali and N. Dilsiz, Polymer Eng. Sci., 30, 485, (1990).

Aucun de ces document n'apporte de solution au problème à la base de l'invention qui consiste à conférer des propriétés d'anti-salissure ou d'anti-mouillabilité à des fibres.

Ils ne suggèrent en aucun cas une solution à une transposition à l'échelle industrielle d'un procédé qui permettrait de traiter des fibres à une vitesse suffisante d'un point de vue économique.

En effet, pour qu'une technique soit économiquement satisfaisante, il faut que la durée de vie des espèces actives (excitées) et le volume qu'elles occupent soit suffisante pour permettre l'action d'un agent de traitement tel qu'un monomère ou un pré-polymère à des vitesses suffisamment élevées. De plus, il convient d'éviter une destruction des fibres ou du dépôt formé par polymérisation du monomère.

### Buts de l'invention

La présente invention vise à fournir un procédé qui permet le dépôt de films de gainage par traitement de surface de fibres textiles afin de leur conférer des propriétés particulières, notamment anti-salissures tout en évitant les inconvénients de l'art antérieur.

Un autre but vise à fournir un procédé qui peut être appliqué à une échelle industrielle.

Un autre but complémentaire de la présente invention est d'effectuer un dépôt homogène sur la surface des fibres.

La présente invention vise également à fournir un dispositif pour la mise en oeuvre du procédé, en particulier elle vise à fournir un dispositif de traitement en continu de fils constitués de fibres textiles.

D'autres buts et avantages apparaîtront dans la description qui suit.

## Principaux éléments caractéristiques de l'invention

La présente invention se rapporte à un procédé de traitement de la surface d'une fibre textile par réaction d'un monomère ou prépolymère intervenant dans un processus de polymérisation en formant un gainage adhérant à la surface de la fibre caractérisé en ce que la fibre est soumise à des phases de procédé successives lors de son passage au travers d'un milieu réactionnel constitué de plasma froid en écoulement qui est obtenu par décharge micro-onde d'un gaz plasmagène d'azote et de monomère et/ou de prépolymère, la première phase s'effectuant en régime de décharge délocalisé de manière à obtenir un traitement préalable de la surface de ladite fibre pour augmenter ses propriétés adhésives et la seconde phase s'effectuant en régime de post-décharge pour obtenir une réaction de polymérisation du gainage adhérant à la surface de la fibre induite par les espèces actives du plasma froid d'azote en écoulement sur le monomère/prépolymère.

Le plasma en écoulement est obtenu par décharge dans un gaz plasmagène de préférence dans l'azote éventuellement dopé, dans un dispositif appelé coupleur constituant une cavité résonnante micro-onde, et connecté à un générateur micro-onde. Les fréquences de le décharge micro-onde sont de préférence de 433 MHz, de 915 MHz, de 2450 MHz ou de toute autre fréquence industrielle.

Cette cavité resonnante possède un tube central par lequel passe le tube en verre véhiculant le gaz plasmagène et qui présente un "gap" (ouverture) où siège un champ électrique important nécessaire à le décharge.

De préférence le gaz plasmagène est un gaz d'azote ($N_2$) éventuellement dopé mais d'autres gaz (Ar, Xe,NO ou $O_2$) peuvent être utilisés.

La présence d'oxygène et/ou de vapeur d'eau dans le plasma agissant comme co-facteur de polymérisation en présence de Ne s'est révélée particulièrement avantageuse. Leur injection peut se réaliser en amont de l'injection du monomère ou du prépolymère ou simultanément avec celui-ci.

De préférence, le dioxygène ($O_2$) est utilisé à des débits variant de 0,1 à 20% du débit de gaz plasmagène.

Le procédé de traitement de la surface d'une fibre peut s'effectuer en continu pour un matériau constitué de fibres textiles, de préférence sous forme d'un fil.

Conviennent tout particulièrement comme monomère ou prépolymère, les dérivés du silicium et de préférence un siloxane ou un silazane.

Le procédé est applicable a la plupart des fibres synthétiques, semi-synthétiques ou naturelles qu'elles soient traitées ou non, en particulier les fibres constituées en un matériau polymérique organique, de préférence en polyamide, en polypropylène ou en polyester.

L'invention porte également sur un dispositif pour la mise en oeuvre du procédé selon la description précédente comportant une zone de décharge délocalisée d'un plasma froid en écoulement et un réacteur alimenté en monomères ou en prépolymères dans lesquels circule successivement le fil à traiter.

D'autres caractéristiques et avantages de l'invention apparaîtront à la lecture du mode d'exécution préféré de l'invention qui suit.

## Brève description des figures

- La figure 1 représente pour les plasmas froids, les températures de translation des particules lourdes et des électrons, en fonction de la pression;
- la figure 2 représente pour un plasma d'azote en écoulement des variations comparées de température de translation et de vibration;
- la figure 3 représente une vue schématique globale du dispositif selon l'invention;
- la figure 4 représente un coupleur 433 MHz en coupe longitudinale;
- la figure 5 représente les lignes de champ d'un coupleur 433 MHz;
- la figure 6 représente le schéma électronique équivalent de la cavité 433 MHz et de son couplage.
- la figure 7 représente des valeurs de vitesse de dépôt en fonction de teneurs croissantes en oxygène dans l'azote servant de gaz plasmagène en présence et en l'absence de vapeur d'eau.

## Définitions

Il convient de définir précisément un plasma froid et en particulier un plasma froid en écoulement par rapport aux plasmas thermiques.

Un plasma est défini comme un milieu gazeux ionisé électriquement neutre, contenant donc des ions positifs, des ions négatifs et des électrons tels que la somme algébrique de leurs charges soit nulle. Il comprend en outre des espèces atomiques ou moléculaires excitées. Expérimentalement, il est obtenu en soumettant un gaz pur ou un mélange gazeux à une excitation externe, qui d'une manière quasi-générale est électrique.

On distingue les plasmas thermiques et les plasmas froids.

Les plasmas thermiques sont obtenus à des pressions supérieures à 100 mb, en général, par injection massive d'énergie électrique (i.e. torche à plasma) et sont à l'équilibre thermodynamique, c'est-à-dire que l'énergie cinétique de chacune des particules peut être mise sous la forme:

$$\epsilon_c = 3/2\ kT$$

où

k = constante de Boltzmann

T = coefficient définissant la température dans le cas de l'équilibre thermodynamique.

Le coefficient T est tel que la température d'équilibre est la même pour toutes les particules. Ceci est également vrai pour la température électronique, et dans le cas de molécules ou ions moléculaires, pour les températures de vibration ou de rotation qui peuvent être déterminées grâce à des expériences de spectroscopie et qui sont notées respectivement: $T_{elec}$, $T_v$ et $T_r$.

Parmi les plasmas froids, deux catégories peuvent être distinguées:

a) Les plasmas froids proprement dits qui sont toujours des gaz à ionisation partielle, à des pressions inférieures à 100 mb. Ils sont obtenus dans une décharge électrique et industriellement on utilise actuellement des décharges hautes fréquences (13,56 MHz) ou micro-ondes (2450 MHz ou 433 MHz, en France - 915 MHz en Grande-Bretagne et aux USA). Il est à remarquer que l'on peut les observer dans le champ électrique et, surtout, dans les systèmes dynamiques en milieu non électrique, mais au voisinage de celui-ci.

Dans la pratique, ces plasmas sont obtenus pour des pressions comprises entre $10^{-2}$ et 2 mB.

La figure 1 caractérise, en fonction de la pression, les températures de translation $T_G$ des particules lourdes (atomes, molécules, ions) et $T_e$ des électrons.

Ce schéma indique que sous une pression faible la température du gaz (translation des particules lourdes) reste relativement faible: la température ambiante pour $p < 10^{-1}$ mb est de l'ordre de 10.000 K et de l'ordre de 1000 K pour $p = 1$ mb tandis que la température, et donc l'énergie cinétique des électrons, est beaucoup plus élevée.

b) Les plasmas froids en écoulement

Ce milieu réactif est obtenu par extraction des espèces excitées, atomiques ou ioniques du plasma précédent après détente, en régime dynamique, dans une enceinte en dehors du champ électrique.

Du point de vue linguistique, le terme plasma est contesté, en particulier pour un tel milieu réactif était jadis connu sous le nom de "gaz atomique", terme tout à fait impropre sauf dans le cas de l'hydrogène. D'autre part, le mot "remote plasma" est apparu dans la littérature scientifique anglo-américaine. Le terme français tout à fait correct doit être plasma post-décharge en écoulement ou plus simplement plasma différé.

Ce milieu réactif est caractérisé par le fait qu':

1) Il est obtenu, en écoulement, par extraction des espèces actives d'une décharge dans un gaz comprenant des molécules. Il convient de souligner que cette propriété n'est pas tout à fait générale et qu'un gaz monoatomique peut donner un plasma différé par formation de molécules excimères accompagnant les états atomiques excités métastables.

2) Il ne contient pas d'ions ou d'électrons en quantité appréciable et est composé:

d'atomes libres - en général à l'état fondamental, dont la reactivité tient au caractère radicalaire.

Exemple: $H(^2S)$ monoradical libre
$O(^3P)$ diradical libre
$N(^4S)$ triradical libre

- d'espèces moléculaires diatomiques électroniquement ou vibrationnellement excitées à durée de relaxation relativement longue.

Exemple: diazote: $N_2\ {}^1\Sigma_v$ état fondamental vibrationnellement excité

$N_2$ $^3\Sigma$ premier état triplet à caractère de diradical
dioxygène: $O_2(^1\Sigma)$ et $O_2(^1\Delta)$ états métastables chimiquement réactif du dioxygène.

3) Il est caractérisé par un non équilibre thermodynamique important qui peut être quantifié de la manière suivante : Si on appelle:

$T_G$ la température de translation des atomes et molécules voisin de la température ambiante,
$T_D$ la température de dissociation en atomes de la molécule
$T_V$ la température de vibration,
$T_{elec}$ la température de l'excitation électronique de molécule diatomique,

les valeurs de $T_D$, $T_V$, $T_{elec}$ sont très élevées et variables suivant le système envisagé; elles diminuent avec la pression du fait des relaxations par collisions.

A titre d'exemple, la courbe représentée à la figure 2 indique les variations comparées de température de translation et de vibration pour un plasma d'azote.

Les plasmas post-décharges sont obtenus principalement avec des gaz diatomiques homonucléaires:

- $O_2$ (espèces actives: $O(^3P)$, $O_2(^1\Delta)$, $O_2(^1\Sigma)$)
- $N_2$ (espèces actives: $N(^4S)$, $N_2(^1\Sigma)_v$ excité, $N_2(^3\Sigma)$)

Il convient de noter que la mécanistique particulière des plasmas d'azote leur permet d'avoir une "durée de vie" et une extension en volume beaucoup plus importantes que celles de l'oxygène par exemple. Par ailleurs, il faut également noter l'existence d'autres gaz plasmagènes intéressants: CO, $CO_2$, $NO_2$... .

Enfin, les propriétés d'un plasma peuvent être orientées par un agent dopant par exemple le $NF_3$, le $CF_4$, les gaz halogènes et surtout dans le cas du plasma post-décharge d'azote, le $NH_3$.

Enfin, le plasma différé d'azote possède une viscosité très faible qui rend possible son action pour tout type de géométrie.

En résumé, on peut différentier le plasma de décharge et le plasma post-décharge de la manière suivante:

Plasma de décharge, effet primaire: bombardement par des électrons rapides. Les oxydations observées expérimentalement ont pour origine l'action de l'oxygène atomique ou moléculaire sur les radicaux libres créés en surface du substrat plastique par le bombardement des électrons.
Pression de travail: < 1 mB
Viscosité du plasma: élevée.

Plasma post-décharge, effet primaire: réactions radicalaires de surface d'atomes libres ou de molécules excitées créant une fonctionnalisation de la surface du substrat.
Pression de travail: < 50 mB (plasma d'azote)
Viscosité du plasma: faible
Extension en volume: importante (plasma d'azote).

## Description d'un mode d'exécution préféré de l'invention

La présente invention recouvre deux processus distincts et successifs:

1°) Le premier processus qui consiste en un passage de la fibre dans un plasma froid d'azote en écoulent a pour objet d'augmenter la mouillabilité et par conséquent les propriétés adhésives de la fibre.

2°) Le second processus est relatif à la création d'un dépôt polymérique sous forme de gainage sur la fibre. Cette polymérisation est induite par les espèces actives (radicalaires ou non) du plasma froid d'azote en écoulement.

Le plasma froid en écoulement, généré à 433 MHz présente trois régimes:

- le régime de décharge localisée au coupleur (4),
- le régime de décharge délocalisée (14),
- le régime de post-décharge (15).

Un dispositif convenant pour la mise en oeuvre du procédé selon l'invention est représenté à la figure 3.

Dans ce dispositif, il s'agit de traiter en continu un fil constitué de fibres textiles, de préférence en polyamide.

Des fibres en toute autre matière organique polymérique en particulier en polypropylène ou en polyester conviennent également à cette application.

Le fil 1 est introduit à partir d'une bobine d'entrée 20 dans le dispositif maintenu sous vide partiel par l'intermédiaire d'un joint 6 constitué d'une colonne de mercure en U de 760 mm de haut.

Le fil est ensuite essuyé par un essuyeur 7 et amené dans la zone de décharge délocalisée 14 d'un plasma froid en écoulement.

Le gaz plasmagène 2 est constitué d'azote éventuellement dopé par de l'oxygène ou par des gaz rares.

Le gaz est détendu et aspiré à l'aide d'une pompe 9. Le débit du gaz est réglé par débitmètre 10. Le gaz plasmagène 2 est ainsi introduit dans un tube à décharge 12 en pyrex traversant la cavité résonnante formant le coupleur 4. La décharge est produite par transfert d'énergie fournie par le générateur 5 micro-onde au gaz plasmagène. Il se produit dans ce cas des zones de décharge délocalisée 14 en aval de la cavité.

Le fil 1 après passage dans ces zones de décharge délocalisée 14 d'un plasma froid en écoulement où il subit une augmentation des propriétés de l'adhérence est ensuite amené dans le réacteur 13.

On injecte dans ce réacteur 13 par la buse d'injection 19 des monomères ou prépolymères à l'état gazeux.

Préalablement, si le monomère ou prépolymère est à l'état liquide dans des conditions normales de température et de pression, on chauffe le monomère contenu dans un réservoir 3 dans un évaporateur 8 entouré d'un cordon chauffant 17, régulé par un rhéostat 16. Un condenseur 18 peut recueillir le monomère condensé.

Le fil circule dans une partie rétrécie 15 du réacteur 13 où se produit la polymérisation du monomère ou du prépolymère en formant un gainage adhérant à la surface du fil 1.

Le fil ressort par un joint d'étanchéité 6' similaire à 6, un essuyeur 7' et est bobiné sur la bobine 21 par le bobinoir 22.

Un capteur de pression 11 permet de mesurer la pression régnant dans le dispositif.

Les monomères utilisés sont de préférence des dérivés du silicium, en particulier des siloxanes de formule générale

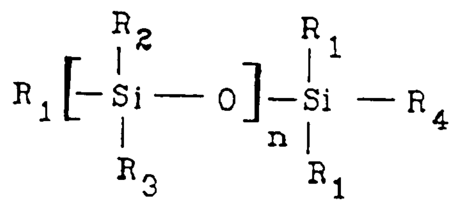

où

| | |
|---|---|
| $R_1$ et $R_4$ | sont des groupements aliphatiques |
| $R_2$ | est un groupement méthyle, hydroxyle, éthyle ou carboxyle |
| $R_3$ | est un groupement méthyle |

et

n est compris entre 1 et 40

ou encore des monomères cycliques tels que l'octaméthyltétracyclosiloxane

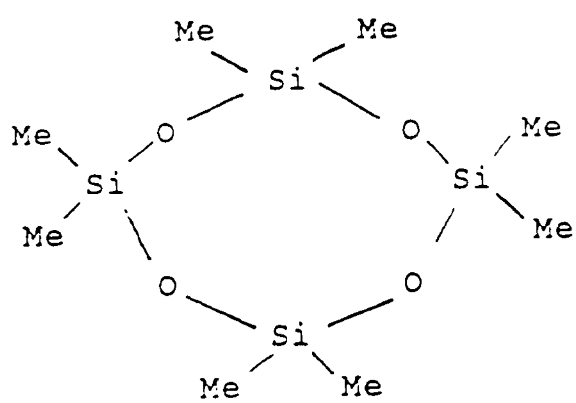

où Me est le radical méthyle.

Les composés organiques,halogénés, de préférence fluorés conviennent également pour ce traitement.

La polymérisation des monomères qui s'amorce dans la zone de polymérisation 15 permet d'obtenir un film de polymères constituant un gainage adhérent sur la surface des fibres.

Un capteur de pression 11 permet de contrôler la pression qui doit être maintenue à des valeurs voisines de 0,10 mbar.

Le fil 1 passe au travers d'un second système d'étanchéité 6' et est essuyé par un essuyeur 7' avant d'être enroulé sur une bobine de sortie 22 placée sur un bobinoir 21 lui-même entraîné par un moteur.

La figure 4 représente le coupleur 433 MHz plus en détail.

La cavité résonnante 433 MHz constituant le coupleur est de type coaxial et possède un tube central 403 coaxial qui permet le passage du tube de décharge en verre véhiculant le gaz plasmagène. Ce tube central 403 présente une ouverture 404 appelée un "gap" où siège un champ électrique important nécessaire à la décharge. Les lignes de champ de la cavité sont représentées à la figure 5.

Le potentiel du tube central 403 est de 310 V pour une puissance maximum de 400 W et le potentiel de la surface externe 408 de la cavité est à 0 V.

Ce potentiel est déterminé par calcul en l'absence de plasma, en fonction de la géométrie pour la puissance maximale.

Le rapport du rayon de la surface externe 408 au rayon du tube central 403 est également choisi de manière à obtenir un courant de surface maximum dans le plasma.

Un condensateur d'accord 402 est disposé à l'entrée de la cavité. Un bouton à pas fin 401 permet un réglage de la valeur du condensateur 402 permettant ainsi d'accorder la partie réactive du circuit. Un schéma équivalent de la cavité de son couplage est représenté à la figure 6 où

- C représente le condensateur d'accord variable,
- $C_c$ et $L_c$ représentent respectivement le condensateur et la self de la cavité,
- $Z_p$ représente l'impédance du plasma et
- G représente le générateur micro ondes.

Quatre lumières 406 permettent en outre de faire varier la longueur du gap 404 ce qui modifie l'impédance $Z_e$ du circuit équivalent.

On a également prévu un piège à ondes 405 afin de limiter les pertes d'énergie vers l'extérieur.

Le refroidissement du tube de décharge est assuré par un passage d'air comprimé 407.

## Exemple

L'effet de la présence d'$O_2$ à des débits variables par rapport au débit du gaz plasmagène $N_2$ sur le dépôt de tétraméthyldisiloxane (TMDS) a été étudié en recueillant le polymère sur plaque de zinc anhydre et plaque de zinc humide (0,5% HR).

Le rôle présumé du gaz co-agent semble pouvoir être expliqué par l'influence qu'il a sur les vecteurs d'énergie du plasma:

| | | | |
|---|---|---|---|
| $N_2(A^3\Sigma_u^+) + N(^4S)$ | → | $N_2(X^1\Sigma_g^+)_v + N(^4S)$ | (1) |
| $N(^4S) + N(^4S)$ | → | $N_2(A^3\Sigma_u^+) + h\nu$ | (2) |
| $N(^4S) + O_2(^3\Sigma_g^-)$ | → | $NO(X^2\Pi) + O(^3\rho)$ | (3) |
| $N(^4S) + O(^3\rho)$ | → | $NO(X^2\Pi)$ | (4) |

Les réactions (1) et (2) sont compétitives et (2) prépondérante.

La réaction (2) est plus énergétique que (1).

L'inhibition de $N_2(A^3\Sigma_u^+)$ par $O_2$ déséquilibre (2) favorisant la recombinaison de $N(^4S)$ et permet d'obtenir un plasma plus énergétique.

L'augmentation du taux de gaz co-agent tend à désactiver $N(^4S)$ (équations (3) et (4)) et donc à diminuer la concentration des vecteurs d'énergie dans le plasma.

Un maximum d'énergie peut être obtenu à l'équilibre entre l'inhibition de $N_2(A^3\Sigma_u^+)$ et la désactivation de $N(^4S)$.

TABLEAU I

| Le tableau présente les différentes valeurs de vitesse de dépôt obtenues selon le mode d'exécution préféré: | | | | |
|---|---|---|---|---|
| Débit $O_2$ slpm | % $O_2$ % | Pression mB | Vdépôt a) mg/cm²/h | Vdépôt b) mg/cm²/h |
| 0,000 | 0 | 4,0 | 2,90 | 2,92 |
| 0,015 | 1 | 4,0 | 4,82 | 4,90 |
| 0,030 | 2 | 4,0 | 6,70 | 7,65 |
| 0,045 | 3 | 4,1 | 7,20 | 9,15 |
| 0,060 | 4 | 4,1 | 7,88 | 10,02 |
| 0,075 | 5 | 4,2 | 7,71 | 10,65 |
| 0,090 | 6 | 4,2 | 7,50 | 12,10 |
| 0,105 | 7 | 4,2 | 6,90 | 12,40 |
| 0,120 | 8 | 4,4 | 6,10 | 11,30 |
| 0,135 | 9 | 4,4 | 4,80 | 9,10 |
| 0,150 | 10 | 4,4 | 4,15 | 5,80 |
| F = 433 MHz Pabs = 360 W<br>Gaz plasmagène = $N_2$ débit $N_2$ = 1,5 slpm<br>Gaz monomère = tétraméthyldisiloxane (TMDS) débit = 1,5 cc/h<br>Gaz co-agent = $O_2$ | | | | |

a) Polymère recueilli sur plaque de zinc anhydre
b) Polymère recueilli sur plaque de zinc 0,5% HR

Ces résultats expérimentaux sont repris à la figure 7. La courbe supérieure (cercle noir) est celle obtenue sur plaque de zinc humide. La courbe inférieure (carré blanc) est obtenue pour le cas d'une plaque de zinc anhydre.

**Revendications**

1. Procédé de traitement de la surface d'une fibre textile par réaction d'un monomère ou prépolymère intervenant dans un processus de polymérisation en formant un gainage adhérant à la surface de la fibre caractérisé en ce que la fibre est soumise à des phases de procédé successives lors de son passage au travers d'un milieu réactionnel constitué de plasma froid en écoulement qui est obtenu par décharge micro-onde d'un gaz plasmagène d'azote et de monomère et/ou de prépolymère, la première phase s'effectuant en régime de décharge délocalisé de manière à obtenir un traitement préalable de la surface de ladlte fibre pour augmenter ses propriétés adhésives et la seconde phase s'effectuant en régime de post-décharge pour obtenir une réaction de polymérisation du gainage adhérant à la surface de la libre induite par les espèces actives du plasma froid d'azote en écoulement sur le monomère/prépolymère.

2. Procédé de traitement de la surface d'une fibre selon la revendication 1 caractérisé en ce que la décharge est produite à une fréquence de 433 MHz, ou de 915 MHz ou de 2O50 Mhz.

3. Procédé de traitement de la surface d'une fibre selon la revendication 1 ou 2 caractérisé en ce que le gaz plasmagène est un gaz d'azote dopé.

4. Procédé de traitement de la surface d'une libre selon la revendication 3 caractérisé par l'utilisation de l'oxygène et/ou de la vapeur d'eau comme co-facteur de polymérisation.

5. Procédé de traitement de la surface d'une libre selon la revendication 4 caractérisé en ce que l'injection du co-facteur de polymérisation s'effectue en amont de l'injection de monomère ou de prépolymère ou simultanément avec celui-ci.

6. Procédé de traitement de la surface d'une libre selon l'une quelconque des revendications précédentes caractérisé en ce que le traitement s'effectue en continu pour un matériau constitué de libres textiles sous forme d'un fil.

7. Procédé de traitement de la surface d'une fibre selon l'une quelconque des revendications précédentes caractérisé en ce que la fibre est constituée en un matériau polymérique, notamment en polyamide, en polypropylène ou en polyester.

8. Procédé de traitement de la surface d'une fibre selon l'une quelconque des revendications précédentes caractérisé en ce que le monomère ou prépolymère est un dérivé du silicium, notamment un siloxane ou un silazane.

9. Dispositif pour la mise en oeuvre du procédé selon l'une quelconque des revendications précédentes caractérisé en ce qu'il comporte, une zone de décharge délocalisée (14) d'un plasma froid d'azote en écoulement et un réacteur (13) alimenté en monomère et/ou en prépolymère dans lesquels circule successivement et en continu un fil à traiter (1), la décharge dans le gaz plasmagène d'azote (2) étant obtenue dans un coupleur (4) constituant une cavité résonnante reliée à un générateur micro-onde (5).

10. Dispositif selon la revendication 9 caractérisé en ce que le dispositif est maintenu sous vide partiel à l'aide de joints d'étanchéité (6) et (6') constitués de colonnes de mercure en U de 760 mm de haut.

11. Dispositif selon la revendication 9 ou 10 caractérisé en ce que le coupleur micro-onde est constitué d'un tube central (403) coaxial par lequel passe le tube de décharge en verre véhiculant le gaz plasmagène présentant un gap (404) où siège le champ électrique nécessaire à la décharge.

12. Dispositif selon la revendication 11 caractérisé en ce que le coupleur comporte un condensateur d'accord (402) disposé à l'entrée de la cavité et qui est réglé de manière à accorder la partie réactive du circuit.

13. Dispositif selon la revendication 11 ou 12 caractérisé en ce que quatre lumières (406) permettent de faire varier la longueur du gap (404);

14. Dispositif selon l'une quelconque des revendications 12 à 13 caractérisé en ce que le coupleur comporte un piège à ondes (405) limitant les pertes d'énergie vers l'extérieur.

15. Dispositif selon l'une quelconque des revendications 11 à 14 caractérisé en ce que le tube de décharge est refroidi par un passage d'air comprimé (407).

## Claims

1. Process for treating the surface of a textile fiber by reaction of a monomer or prepolymer taking place in a polymerization process forming a sheathing adhering to the surface of the fiber, characterized in that the fiber is subjected to successive process phases during its passage through a reaction medium consisting of cold flowing plasma which is obtained by microwave discharge of a nitrogen plasma producing gas and of monomer and/or prepolymer, the first phase of the process being performed in the delocalized discharge discharge regime in order to achieve a prior treatment of the surface of said fiber to increase its adhesive properties and the second phase being performed in the post-discharge regime in order to achieve a polymerization reaction of the sheathing adhering to the surface of the fiber induced by the active spices of the cold flowing nitrgoen plasma on the monomer/prepolymer.

2. Process for treating the surface of a fiber according to claim 1, characterized in that the discharge is produced at a frequency of 433 MHz, or of 915 MHz or of 2450 MHz.

3. Process for treating the surface of a fiber according to claim 1 or 2, characterized in that the plasma-producing gas is a doped nitrogen gas.

4. Process for treating the surface of a fiber according to claim 3, characterized by the use of oxygen and/or water vapor as polymerization cofactor.

5. Process for treating the surface of a fiber according to claim 4, characterized in that the injection of the polymerization cofactor is performed upstream of the injection of monomer or of prepolymer or simultaneously with the latter.

6. Process for treating the surface of a fiber according to any one of the preceding claims, characterized in that the treatment is performed continuously for a material consisting of textile fibers in the form of a yarn.

7. Process for treating the surface of a fiber according to any one of the preceding claims, characterized in that the fiber is made of an organic polymer material, in particular of polyamide, polypropylene or polyester.

8. Process for treating the surface of a fiber according to any one of the preceding claims, characterized in that the monomer or prepolymer is a silicon derivative, in particular a siloxane or a silazane.

9. Device for implementing the process according to any one of the preceding claims, characterized in that it comprises a zone of delocalized discharge (14) of a cold nitrogen flowing plasma and a reactor (13) supplied with monomers and/or prepolymer through which a yarn (1) to be treated successively and continuously moves, the discharge of the nitrogen plasma producing gas (2) being obtained in a coupler (4) constituting a resonant cavity joined to a microwave generator (5).

10. Device according to claim 9, characterized in that the device is kept under partial vacuum using seals (6) and (6') consisting of mercury columns in U of 760 mm high.

11. Device according to claim 9 or 10, characterized in that the microwave coupler consists of a central coaxial tube (403) through which there passes the glass discharge tube which conveys the plasma-producing gas having a gap (404) in which the electric field necessary for the discharge is located.

12. Device according to claim 11, characterized in that the coupler comprises a tuning capacitor (402) disposed at the entry of the cavity and which is adjusted so as to tune the reactive part of the circuit.

13. Device according to claim 11 or 12, characterized in that four slots (406) make it possible to cause the length of the gap (404) to vary.

14. Device according to any one of claims 12 to 13, characterized in that the coupler comprises a wave trap (405) limiting energy losses towards the outside.

15. Device according to any one of claims 11 to 14, characterized in that the discharge tube is cooled via a compressed air passage (407).

**Patentansprüche**

1. Verfahren zur Behandlung der Oberfläche einer Textilfaser mittels einer Reaktion eines Monomers oder Vorpolymers, das bei einem Polymerisationsprozeß beteiligt ist, wobei eine an der Oberfläche der Faser haftende Umhüllung gebildet wird, dadurch gekennzeichnet, daß die Faser aufeinanderfolgenden Verfahrensphasen unterworfen wird bei ihrem Durchlauf durch ein Reaktionsmedium, das aus abfließendem, kaltem Plasma, das durch Mikrowellenentladung eines plasmaerzeugenden Stickstoffgases erhalten wird, und Monomer und/oder Vorpolymer besteht, wobei die erste Phase bei der delokalisierten Entladung so abläuft, daß eine vorherige Behandlung der Oberfläche der Faser erhalten wird, um ihr Haftvermögen zu erhöhen, und die zweite Phase bei der Nachentladung abläuft, um eine Polymerisationsreaktion der an der Oberfläche der Faser haftenden Umhüllung zu erhalten, die durch die aktiven Arten des abfließenden, kalten Stickstoffplasmas bei dem Monomer/Vorpolymer eingeleitet wird.

2. Verfahren zur Behandlung der Oberfläche einer Faser, gemäß Anspruch 1, dadurch gekennzeichnet, daß die Entladung bei einer Frequenz von 433 MHz, oder 915 MHz, oder 2050 MHz erzeugt wird.

3. Verfahren zur Behandlung der Oberfläche einer Faser, gemäß Anspruch 1 oder 2, dadurch gekennzeichnet, daß das plasmaerzeugende Gas ein dotiertes Stickstoffgas ist.

**4.** Verfahren zur Behandlung der Oberfläche einer Faser, gemäß Anspruch 3, gekennzeichnet durch die Verwendung von Sauerstoff und/oder Wasserdampf als Polymerisations-Cofaktor.

**5.** Verfahren zur Behandlung der Oberfläche einer Faser, gemäß Anspruch 4, dadurch gekennzeichnet, daß der Polymerisations-Cofaktor stromaufwärts von dem Monomer oder Vorpolymer, oder zusammen mit dem Monomer oder Vorpolymer eingeblasen wird.

**6.** Verfahren zur Behandlung der oberfläche einer Faser, gemäß irgendeinem der vorhergehenden Ansprüche, dadurch gekennzeichnet, daß die Behandlung bei einem aus Textilfasern in Form eines Fadens bestehenden Material kontinuierlich erfolgt.

**7.** Verfahren zur Behandlung der Oberfläche einer Faser, gemäß irgendeinem der vorhergehenden Anspräche, dadurch gekennzeichnet, daß die Faser aus einem polymeren Material, insbesondere aus Polyamid, Polypropylen oder Polyester besteht.

**8.** Verfahren zur Behandlung der Oberfläche einer Faser, gemäß irgendeinem der vorhergehenden Ansprüche, dadurch gekennzeichnet, daß das Monomer oder Vorpolymer ein Siliziumderivat, insbesondere ein Siloxan oder ein Silazan ist.

**9.** Vorrichtung zur Verwirklichung des Verfahrens gemäß irgendeinem der vorhergehenden Ansprüche, dadurch gekennzeichnet, daß sie eine Zone (14) mit delokalisierter Entladung eines abfließenden, kalten Stickstoffplasmas und einem mit Monomer und/oder Vorpolymer versorgten Reaktor (13) umfaßt, durch die ein zu behandelnder Faden (1) nacheinander kontinuierlich hindurchläuft, wobei die Entladung in dem plasmaerzeugenden Stickstoffgas (2) in einem Koppler (4) erhalten wird, der einen Resonanzraum darstellt, der mit einem Mikrowellengenerator (5) verbunden ist.

**10.** Vorrichtung gemaß Anspruch 9, dadurch gekennzeichnet, daß sie mit Hilfe von Dichtungen (6) und (6'), die aus U-förmigen Quecksilbersäulen von 760 mm Höhe bestehen, unter Unterdruck gehalten wird.

**11.** Vorrichtung gemäß Anspruch 9 oder 10, dadurch gekennzeichnet, daß der Mikrowellenkoppler aus einem koaxialen, zentralen Rohr (403) besteht, durch das das gläserne Entladungsrohr hindurchgeht, das das plasmaerzeugende Gas befördert, und das ein Gap (404) aufweist, in dem das für die Entladung erforderliche elektrische Feld herrscht.

**12.** Vorrichtung gemaß Anspruch 11, dadurch gekennzeichnet, daß der Koppler einen Abstimmkondensator (402) umfaßt, der an dem Eingang des Resonanzraums angeordnet ist, und der so eingestellt wird, daß der reaktive Teil der Schaltung abgestimmt ist.

**13.** Vorrichtung gemaß Anspruch 11 oder 12, dadurch gekennzeichnet, daß vier Schlitze (406) ermöglichen, die Länge des Gaps (404) zu verändern.

**14.** Vorrichtung gemäß irgendeinem der Ansprüche 12 und 13, dadurch gekennzeichnet, daß der Koppler eine Wellenfalle (405) umfaßt, die die Energieverluste infolge nach außen dringender Energie begrenzt.

**15.** Vorrichtung gemäß irgendeinem der Ansprüche 11 bis 14, dadurch gekennzeichnet, daß das Entladungsrohr durch vorbeiströmende Druckluft (407) gekühlt wird.

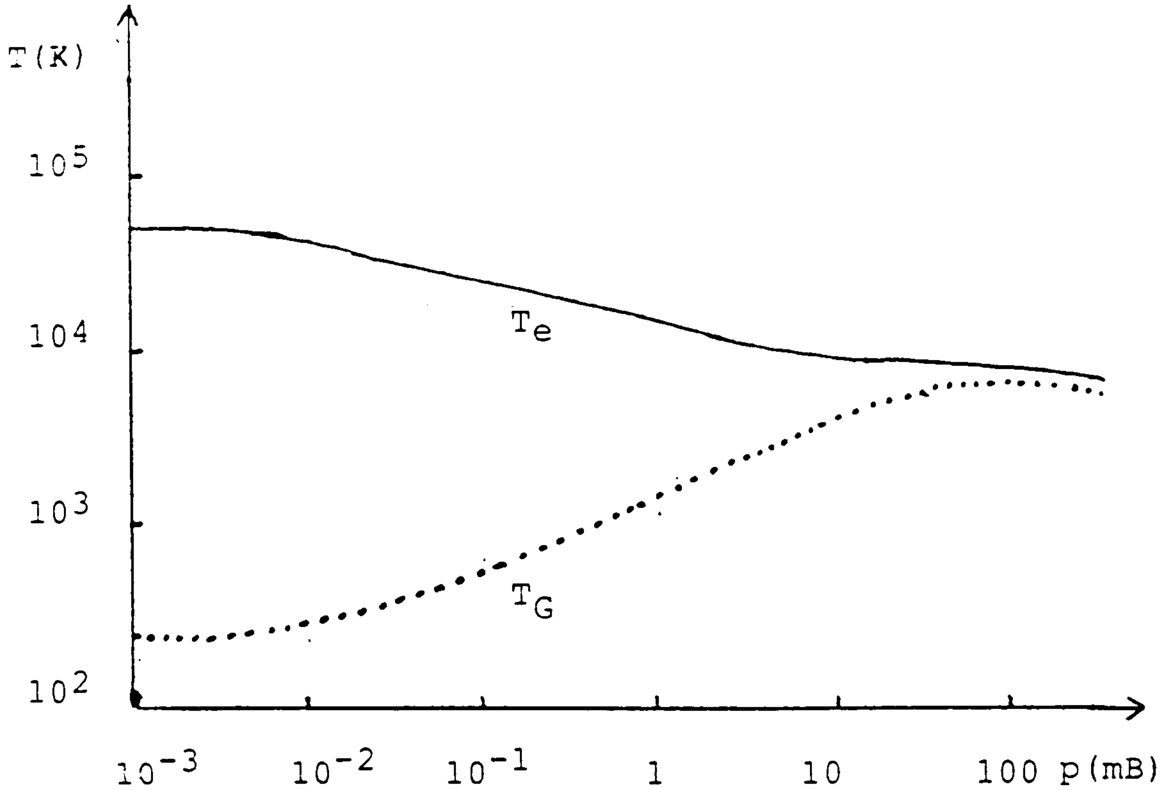
T(K)
$10^5$
$10^4$
$10^3$
$10^2$
$T_e$
$T_G$
$10^{-3}$
$10^{-2}$
$10^{-1}$
1
10
100 p(mB)

Fig.1

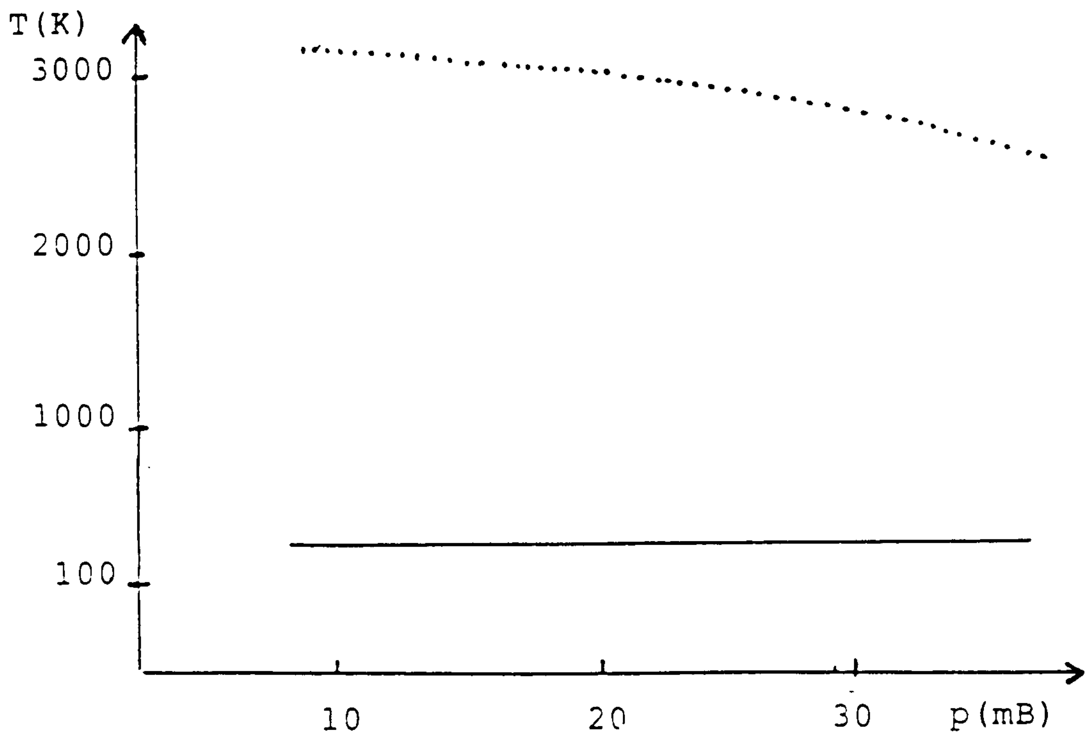
T(K)
3000
2000
1000
100
10
20
30
p(mB)

Fig.2

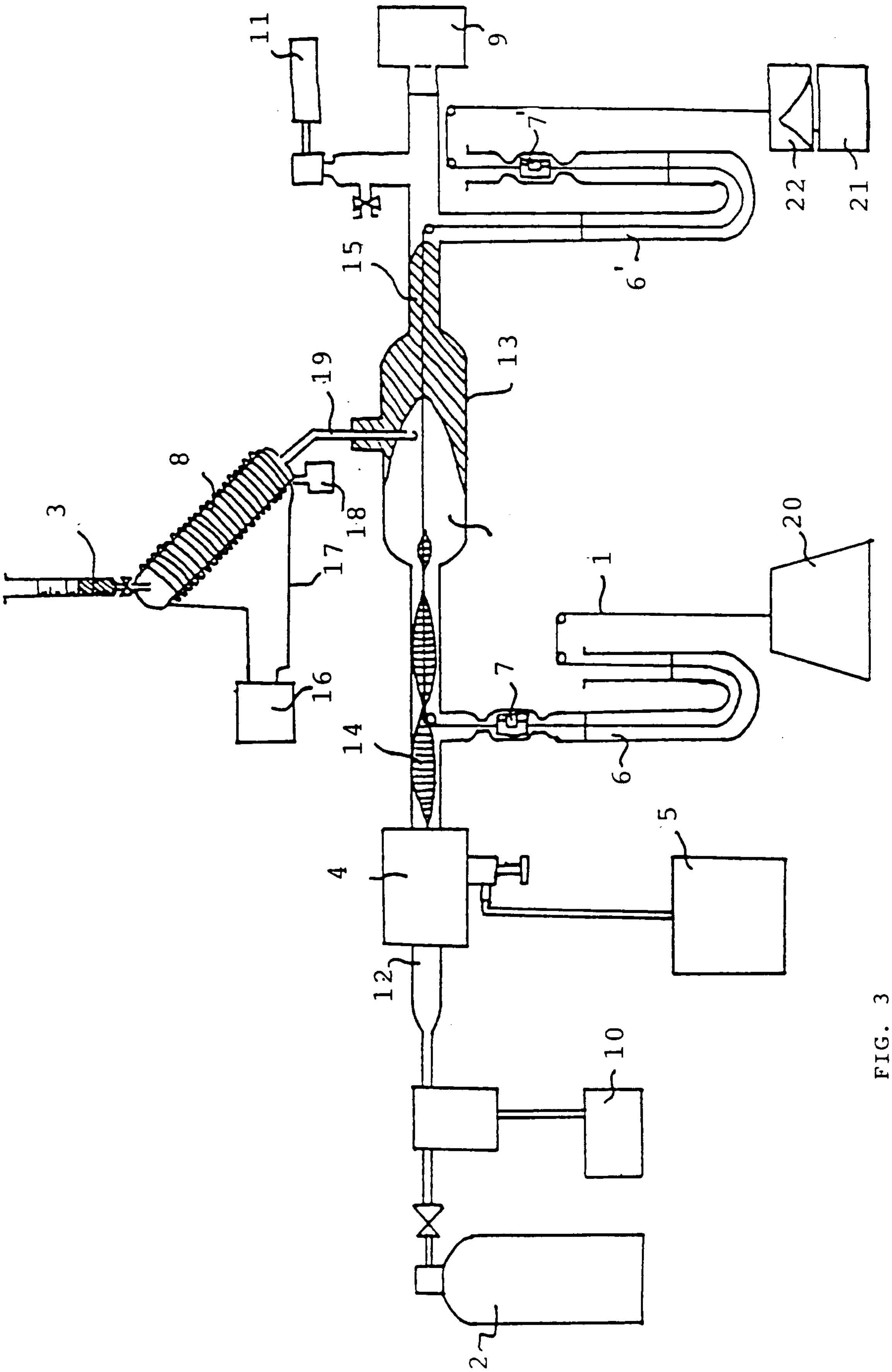


FIG. 3

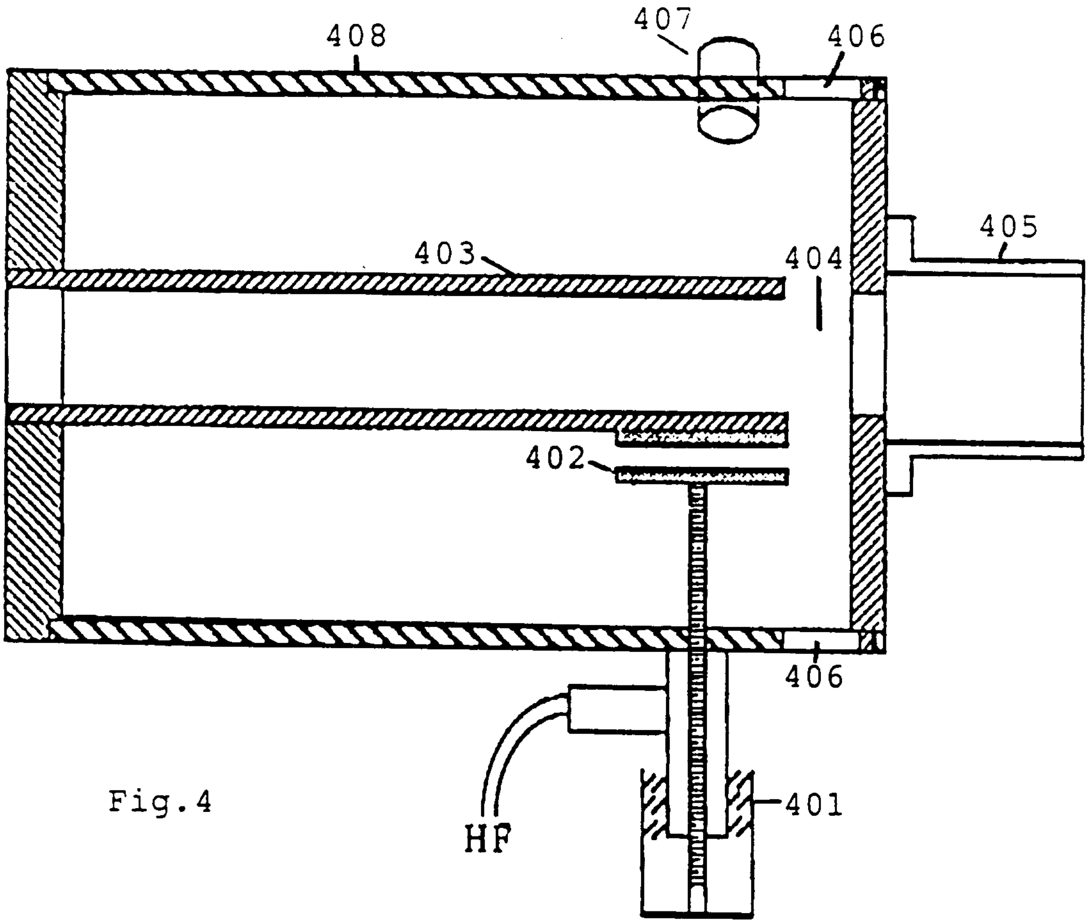


Fig.4

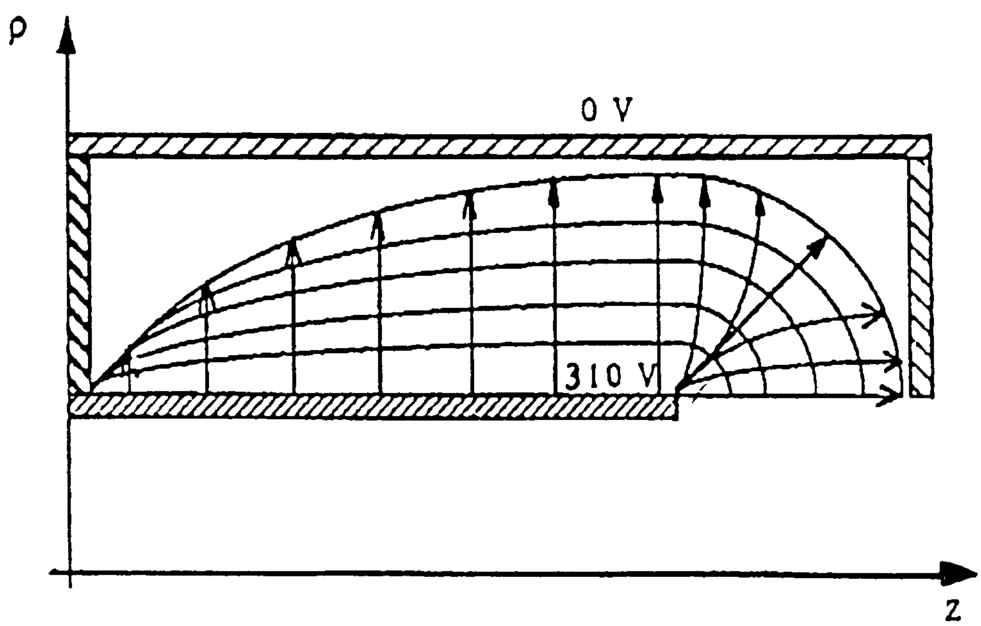


FIG. 5

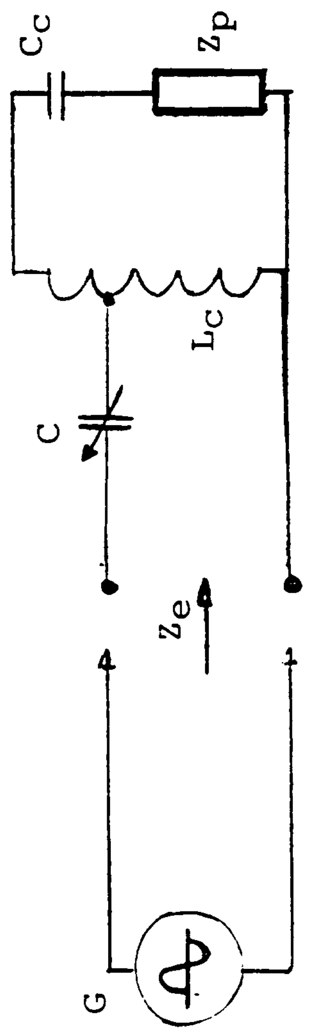


Fig.6

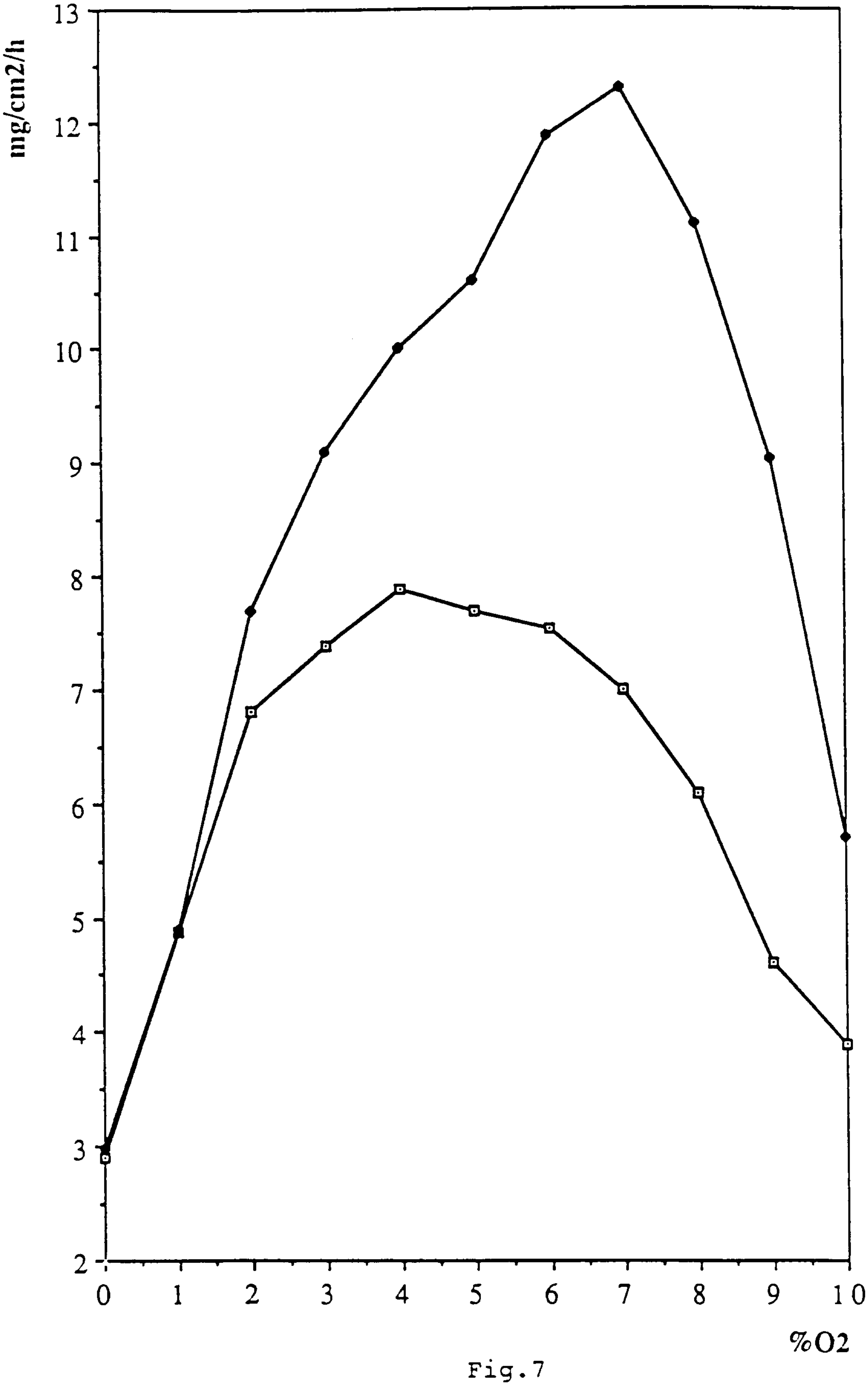


Fig.7